# EUROPÄISCHE PATENTSCHRIFT

(11) **EP 2 208 326 B1**
(45) Veröffentlichungstag und Bekanntmachung des Hinweises auf die Patenterteilung: **09.03.2011**
(21) Anmeldenummer: 08785688.6
(22) Anmeldetag: 22.08.2008
(51) Int. Cl.: H04L 25/03, H03M 13/41

(54) **VITERBI ENTZERRUNG MIT ERMITTLUNG VON NÄCHSTLIEGENDEN KONSTELLATIONSPUNKTEN ZUR ZUSTANDSREDUZIERUNG**
VITERBI EQUALIZATION WITH DETECTION OF THE NEAREST CONSTELLATION POINTS FOR STAGE REDUCTION
CORRECTEUR DE DISTORSION DE VITERBI AVEC DÉTERMINATION DES POINTS DE CONSTELLATION LES PLUS PROCHES POUR LA RÉDUCTION D'ÉTAT

(30) Priorität: 07.11.2007 DE 102007053091
(43) Veröffentlichungstag der Anmeldung: 21.07.2010
(73) Patentinhaber: Rohde & Schwarz GmbH & Co. KG, 81671 München (DE)
(72) Erfinder: KRAKOWSKI, Claudiu, 82194 Gröbenzell (DE)
(74) Vertreter: Körfer, Thomas
(86) Internationale Anmeldenummer: PCT/EP2008/006931
(87) Internationale Veröffentlichungsnummer: WO 2009/059653

(56) Entgegenhaltungen:
- WO-A-99/49634
- DE-A1- 4 427 831
- US-A- 6 151 370
- US-A1- 2003 063 681
- US-A1- 2003 099 311
- US-A1- 2005 268 211
- FOSCHINI G J: "A REDUCED STATE VARIANT OF MAXIMUM LIKELIHOOD SEQUENCE DETECTION ATTAINING OPTIMUM PERFORMANCE FOR HIGH SIGNAL-TO-NOISE RATIOS" IEEE TRANSACTIONS ON INFORMATION THEORY, IEEE, US, Bd. IT-23, Nr. 5, 1. September 1977 (1977-09-01), Seiten 605-609, XP000760818 ISSN: 0018-9448

## Beschreibung

Die Erfindung betrifft ein Verfahren und eine Vorrichtung zum Decodieren faltungscodierter Signale, insbesondere von Empfangssignalen im Mobilfunk und Rundfunk.

Herkömmlich wird zur Decodierung von faltungscodierten Signalen ein Decoder auf Basis des Viterbi-Algorithmus eingesetzt. Bei faltungscodierten Signalen entsprechen die zu übertragenden Daten den Zuständen eines "hidden Markov" Modells. Die tatsächlich übertragenen Daten entsprechen den Zustandsübergängen in dem Modell. Aus den sichtbaren Zustandsübergängen wird durch den Viterbi-Algorithmus auf die Zustände zu einem jeden Zeitpunkt geschlossen. Hierzu wird eine Metrik bestimmt, welche bei gegebenem Empfangssymbol die Wahrscheinlichkeit eines jeden Zustandsübergangs von jedem möglichen gegenwärtigen Zustand zu jedem möglichen folgenden Zustand angibt. Hierzu wird die euklidische Distanz des gegenwärtigen Empfangssymbols zu den Symbolen der Zustandsübergänge bestimmt. Jeder einzelne Zustandsübergang wird dabei als Zweig oder Ast bezeichnet. Durch Aneinanderreihung der einzelnen Zweige wird ein Pfad gebildet. Die Metrik des Pfades ergibt sich durch Summierung der einzelnen Zweig-Metriken.

Der optimale Pfad und damit die wahrscheinlichste Folge von Sendesymbolen sind durch den Pfad geringster Metrik gegeben. Jedes Empfangssymbol enthält bei faltungscodierten Signalen Anteile einer Mehrzahl zeitlich nacheinander angeordneter Symbole. Dies wird als das Gedächtnis des Codes bezeichnet. Dadurch ist der Einfluss eines vergangenen Empfangssymbols auf den gegenwärtigen Zustand limitiert. Nach einer bestimmten Anzahl von Empfangssymbolen ist kein Einfluss des vergangenen Empfangssymbols auf den gegenwärtigen Zustand mehr feststellbar. So wird nach Verstreichen dieser bestimmten Anzahl von Empfangssymbolen die Anzahl der Pfade, die in die weitere Berechnung eingehen auf den wahrscheinlichsten Pfad reduziert. Dieser Schritt wird als Eliminierung der unwahrscheinlichen Pfade bezeichnet. Durch dieses Vorgehen ist ein optimaler Empfänger für das faltungscodierte Signal gegeben.

So wird beispielsweise in der US 3,872,432 B1 eine Vorrichtung zur Synchronisation in einem Viterbi Decoder und damit auch dessen Funktion gezeigt.

Ein Nachteil des Viterbi-Algorithmus ist jedoch die starke Abhängigkeit des Verarbeitungsaufwands von den Parametern des faltungscodierten Signals. So steigt der Aufwand bei einer großen Anzahl von Modulationsstufen wie auch bei einem langen Code-Gedächtnis sehr stark an.

Alternativ werden faltungscodierte Signale durch den Einsatz von "minimum mean-square-error decision-feedback equalizer" (MMSE-DFE) Decodern decodiert. Diese Decoder bestimmen direkt bei Empfang des Symbols den gegenwärtigen Zustand bereits endgültig aus den vergangenen Empfangssymbolen, ohne zukünftige Empfangssymbole zu berücksichtigen.

So wird in der DE 199 48 373 A1 ein MMSE-DFE Decoder gezeigt.

Diese Decoder lösen zwar das Problem des hohen Verarbeitungsaufwands des Viterbi-Decoders, verfügen jedoch über eine wesentlich geringere Detektionssicherheit. So wird insbesondere bei stark gestörten Übertragungskanälen eine hohe Bitfehlerrate des Empfangssignals erzielt.

Das Dokument US 2003/0063681 A1 offenbart ein Übertragungsverfahren bei welchem Senderahmen moduliert über einen ISI-Kanal übertragen werden. Empfangssymbole werden mittels eines modifizierten Viterbi-Algorithmus decodiert. Sequenzen von Zuständen werden dabei einem Zuverlässigkeitsdetektor zugeführt. Anhand einer ermittelten Zuverlässigkeit wird die Decodierung auf eine geringere Anzahl an Zuständen eingeschränkt.

Der Erfindung liegt somit die Aufgabe zu Grunde, ein Verfahren und eine Vorrichtung zur Decodierung von faltungscodierten Signalen zu schaffen, welche bei hoher Detektionssicherheit einen geringen Verarbeitungsaufwand benötigt.

Die Aufgabe wird erfindungsgemäß für das Verfahren durch die Merkmale des unabhängigen Anspruchs 1 und durch die Merkmale des unabhängigen Anspruchs 9 für die Vorrichtung gelöst. Vorteilhafte Weiterbildungen sind Gegenstand der hierauf rückbezogenen Unteransprüche.

Zur Decodierung von faltungscodierten Empfangssymbolen wird ein Viterbi-Decoder eingesetzt. Dabei sind Sendedaten mit einem Modulationsschema zu Symbolen moduliert, welche mit einem Sendefilter zu faltungscodierten Sendesymbolen codiert werden. Ein faltungscodiertes Sendesymbol enthält Anteile mehrerer zeitlich nacheinander angeordneter Symbole. Diese Sendesymbole werden über einen Übertragungskanal übertragen und als Empfangssymbole empfangen. Der Viterbi-Decoder decodiert die Empfangssymbole mittels eines modifizierten Viterbi-Algorithmus. Vor Durchlaufen des Viterbi-Decoders werden die Empfangssymbole von einer Symbol-Reduktions-Einrichtung verarbeitet, welche unabhängig von der Decodierung durch den Viterbi-Decoder in jedem Zustand der Decodierung zusätzliche Informationen, mögliche Folge-Zustände der Decodierung betreffend, ermittelt. Die Symbol-Reduktions-Einrichtung nutzt die zusätzlichen Informationen, mögliche Folge-Zustände der Decodierung betreffend, um die Decodierung durch den Viterbi-Decoder auf bestimmte Folgezustände einzuschränken. Die Symbol-Reduktions-Einrichtung gewinnt das zusätzliche Wissen, mögliche Folge-Zustände betreffend, durch Ermittlung eines intersymbolinterferenzfreien gegenwärtigen Empfangssymbols. Sie gewinnt das intersymbolinterferenzfreie gegenwärtige Empfangssymbol durch gewichtete Subtraktion vergangener intersymbolinterferenzfreier Empfangssymbole von dem gegenwärtigen Empfangssymbol. Die Symbol-Reduktions-Einrichtung bestimmt die Folgezustände durch Ermittlung der Zustände geringster euklidischer Distanz zu dem intersymbolinterferenzfreien gegenwärtigen Empfangssymbol. Durch die Reduktion der möglichen Folgezustände wird der Verarbeitungsaufwand deutlich gesenkt. Gleichzeitig wird eine hohe Detektionsgenauigkeit erreicht, da die wahrscheinlichsten Folgezustände als mögliche Folgezustände ausgewählt werden. Weiterhin kann so mit hoher Sicherheit eine Reihe von möglichen Folgezuständen ermittelt werden.

Das Modulationsschema ist bevorzugt eine Phasenmodulation (PSK) und die Symbol-Reduktions-Einrichtung schränkt bevorzugt die weitere Decodierung auf zwei bestimmte Folgezustände ein. Eine Einschränkung auf zwei Folgezustände reduziert den Verarbeitungsaufwand besonderes stark.

Das Modulationsschema ist vorteilhafterweise eine 8-stufige Phasenmodulation (8-PSK) oder eine 16-stufige Phasenmodulation (16-PSK). Die Reduktion des Verarbeitungsaufwands der Decodierung von Signalen, welche mit einer Vielzahl von Modulationsschemata moduliert sind, ist möglich.

Das Modulationsschema ist bevorzugt eine Quadraturamplitudenmodulation (QAM) und die Symbol-Reduktions-Einrichtung schränkt bevorzugt die weitere Decodierung auf vier bestimmte Folgezustände ein. Bei hoher Übertragungsrate ist gleichzeitig eine deutliche Reduzierung des Verarbeitungsaufwands gegeben.

Das Modulationsschema ist bevorzugt eine 16-stufige oder 32-stufige oder 64-stufige Quadraturamplitudenmodulation. Die Reduktion des Verarbeitungsaufwands der Decodierung von Signalen, welche mit einer Vielzahl von Modulationsschemata moduliert sind, ist möglich.

Der Viterbi-Decoder ermittelt bevorzugt in jedem Zustand der Decodierung mit dem Viterbi-Algorithmus zumindest einen Pfad, der mit geringer Wahrscheinlichkeit die korrekte Folge von Sendesymbolen ergibt und eliminiert bevorzugt diesen zumindest einen Pfad aus der weiteren Decodierung. So wird der Verarbeitungsaufwand der Decodierung weiter reduziert. Die Sicherheit der Detektion wird dabei nicht wesentlich verringert.

Ein Filter filtert bevorzugt die Empfangssymbole vor der Decodierung. Die Filterung durch das Filter reduziert bevorzugt den Einfluss vergangener Symbole auf das faltungscodierte Empfangssymbol und erhöht bevorzugt den Einfluss des gegenwärtigen Symbols auf das faltungscodierte Empfangssymbol. Damit wird die Sicherheit der ermittelten Folgezustände erhöht. Gleichzeitig ist der zusätzliche Verarbeitungsaufwand sehr gering.

Die Koeffizienten des Filters und die Gewichtungsfaktoren zur Ermittlung des intersymbolinterferenzfreien gegenwärtigen Empfangssymbols werden bevorzugt durch Optimierung bestimmt. So werden optimale Filterkoeffizienten und Gewichtungsfaktoren ermittelt.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: ein Blockdiagramm eines Sende- und Empfangspfades eines faltungscodierten Signals;
- Fig. 2: ein beispielhaftes Zustandsdiagramm eines Viterbi-Decoders;
- Fig. 3: ein beispielhaftes Zustandsdiagramm eines modifizierten Viterbi-Decoders;
- Fig. 4: ein Blockdiagramm eines MMSE-DFE Decoders;
- Fig. 5: ein erstes Blockdiagramm eines Ausführungsbeispiels der erfindungsgemäßen Vorrichtung;
- Fig. 6: ein zweites Blockdiagramm eines Ausführungsbeispiels der erfindungsgemäßen Vorrichtung;
- Fig. 7: die Impulsantwort eines beispielhaften Sendefilters für faltungscodierte Signale;
- Fig. 8: die durch ein Filter auf Empfangsseite umgeformte Impulsantwort eines beispielhaften Sendefilters für faltungscodierte Signale;
- Fig. 9: ein erstes beispielhaftes Modulationsschema;
- Fig. 10: ein zweites beispielhaftes Modulationsschema;
- Fig. 11: ein beispielhaftes Zustandsdiagramm eines ersten Ausführungsbeispiels des erfindungsgemäßen Decoders;
- Fig. 12: ein beispielhaftes Zustandsdiagramm eines zweiten Ausführungsbeispiels des erfindungsgemäßen Decoders, und
- Fig. 13: ein Diagramm der Resultierenden Bitfehlerwahrscheinlichkeiten verschiedener Decodier-Verfahren.

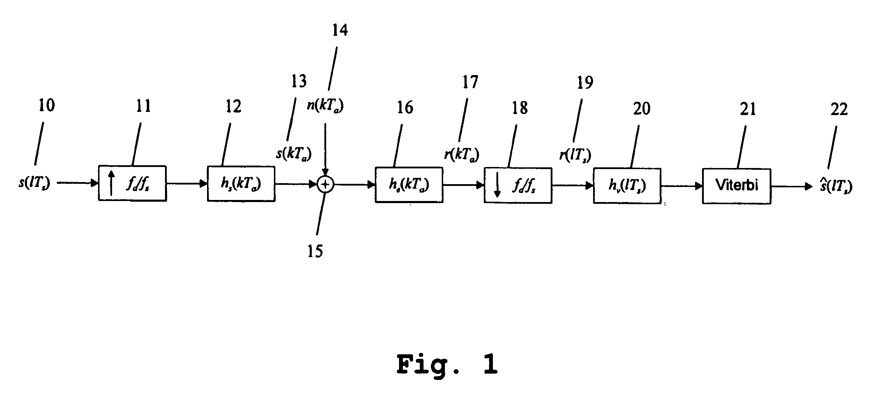

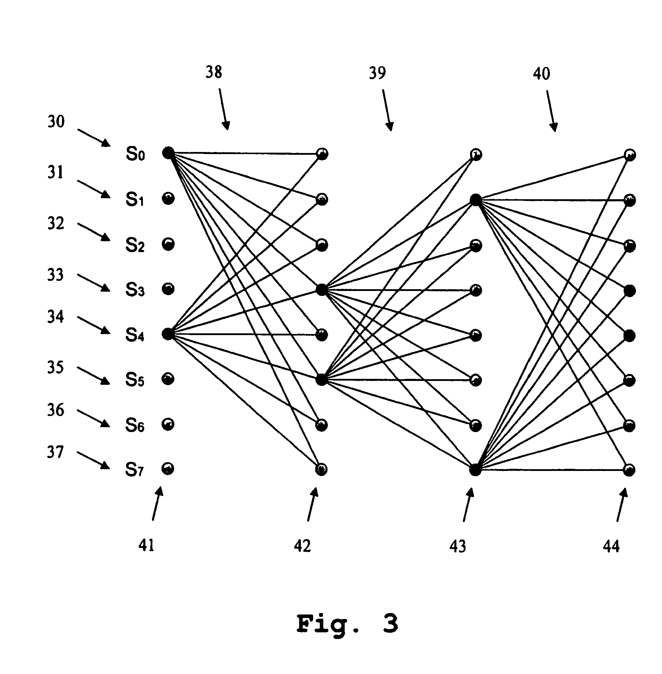

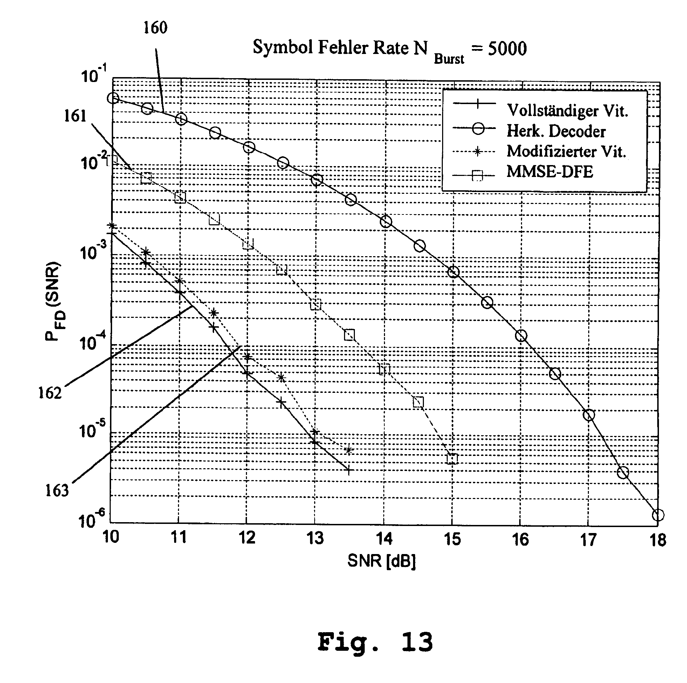

Zunächst wird anhand der Fig. 1 - 2 der Aufbau und die Funktionsweise des bislang gebräuchlichen Viterbi-Decoders gezeigt. Mittels Fig. 3 - 12 wird der Aufbau und die Funktionsweise der erfindungsgemäßen Vorrichtung und des erfindungsgemäßen Verfahrens veranschaulicht. Anhand der Fig. 13 wird das Decodier-Ergebnis der erfindungsgemäßen Vorrichtung gegenüber dem Stand der Technik gezeigt. Identische Elemente wurden in ähnlichen Abbildungen zum Teil nicht wiederholt dargestellt und beschrieben.

In Fig. 1 wird ein Blockdiagramm eines Sende- und Empfangspfades eines faltungscodierten Signals dargestellt. Die Sendesymbolfolge s (1Tₛ) 10 im Basisband wird durch die Modulationseinrichtung 11 auf die Sendefrequenz moduliert. Das Sendefilter 12 prägt dem Signal seine Impulsantwort auf. Das Signal 13 wird über den Kanal übertragen. Dieser ist durch additives weißes Rauschen 14, welches in einem Addierer 15 addiert wird, modelliert. Auf der Empfangsseite wird das Empfangssignal durch einen Empfangsfilter 16 gefiltert. Das gefilterte Empfangssignal 17 wird von der Demodulationseinrichtung 18 zu einem Basisband-Signal 19 demoduliert. Ein Decodierfilter 20 bereitet das Signal 19 auf, bevor der Viterbi-Decoder 21 das Signal zu der Empfangssymbolfolge 22 decodiert.

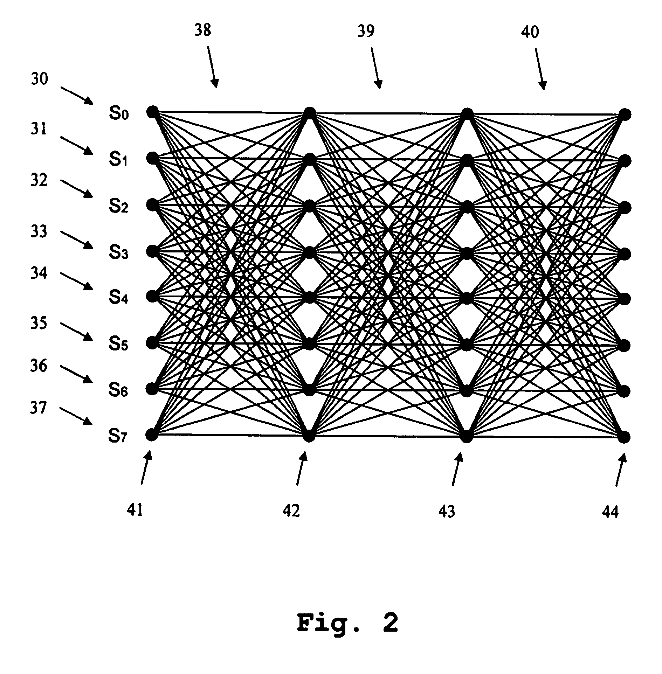

Fig. 2 zeigt ein beispielhaftes Zustandsdiagramm eines Viterbi-Decoders. Die Zustände 30 - 37 und ihre Verbindungsmöglichkeiten 38 - 40 sind über die Zeitpunkte 41 - 44 dargestellt. Jeder Zustand 30 - 37 zu einem bestimmten Zeitpunkt 41 - 44 ist dabei mit jedem Zustand 30 - 37 des darauffolgenden Zeitpunkts 41 - 44 verbunden. Für jede Verbindung der Zustände wird die Zweigmetrik berechnet. Hierzu wird die euklidische Distanz des jeweiligen Empfangssymbols zu den einzelnen, den Zweigen zugeordneten Empfangssymbolen berechnet. D.h. es werden für einen Zustandsübergang 64 Zweigmetriken und für das gesamte dargestellte Zustandsdiagramm 192 Zweigmetriken berechnet. Weiterhin werden aus den Zweigmetriken die Pfadmetriken berechnet. Da sämtliche Pfade des gesamten Zustandsdiagramms berücksichtigt werden, werden 4096 Pfadmetriken berechnet. Dies entspricht bereits einem nennenswerten Verarbeitungsaufwand. Wenn man nun von einem Modulationsschema mit mehr als 8 Zuständen, z.B. 64 Zuständen und einem Code-Gedächtnis von mehr als drei vergangenen Zuständen ausgeht, so steigt der Decodieraufwand in nicht mehr einfach handhabbare Größenordnungen an.

Fig. 3 zeigt ein beispielhaftes Zustandsdiagramm eines modifizierten Viterbi-Decoders. Zur Reduktion des Verarbeitungsaufwands werden hier nach der Berechnung der Zweigmetriken und Pfadmetriken für einen Zeitpunkt lediglich die zwei Pfade größter Wahrscheinlichkeit, d.h. geringster Metrik weiterverfolgt. Die übrigen Pfade werden eliminiert. So werden zum Zeitpunkt 41 lediglich die von Zustand 30 und 34 ausgehenden Pfade weiterverfolgt. Zum Zeitpunkt 42 werden lediglich die von Zustand 33 und 35 ausgehenden Pfade weiterverfolgt. Zum Zeitpunkt 43 werden lediglich die von Zustand 31 und 37 ausgehenden Pfade weiterverfolgt. Damit lässt sich der Verarbeitungsaufwand um Größenordnungen senken. Die Detektionssicherheit wird hierdurch jedoch reduziert, da vorzeitig potentiell nützliche Information verworfen wird. Fälle, in welchen das korrekte Empfangssymbol auf einem unwahrscheinlichen und damit eliminierten Pfad liegen, werden nicht korrekt decodiert, obwohl hierfür genügend Informationen in dem Empfangssignal enthalten sein könnten.

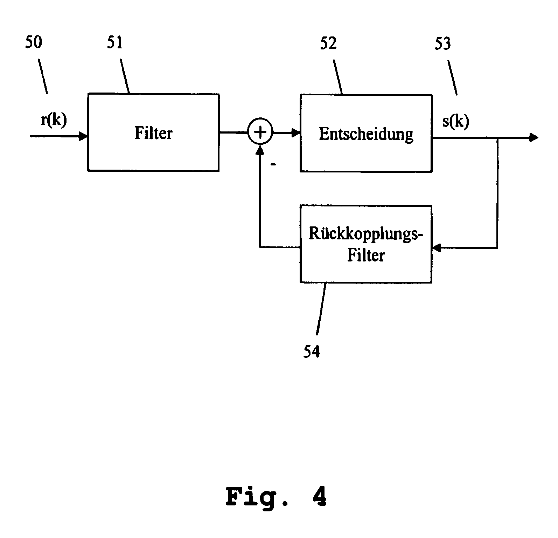

In Fig. 4 wird ein Blockdiagramm eines "minimum mean-square-error decision-feedback equalizer" Decoders (MMSE-DFE) dargestellt. Anstatt den gesamten Pfad möglicher Zustandsübergänge zu berücksichtigen, wird bei dieser Art des Decoders jeder Zustand für sich betrachtet und lediglich der Einfluss vergangener Zustände betrachtet. Hierzu stellt zunächst ein Filter 51 eine Minimalphasigkeit des Empfangssignals 50 her. D.h. der Einfluss des gegenwärtigen Symbols auf das Empfangssymbol wird verstärkt, während der Einfluss der vergangenen Symbole auf das Empfangssymbol verringert wird. Anhand dieses gefilterten Signals und Informationen aus bereits decodierten Symbolen wird in einem Entscheider 52 der Wert des gegenwärtigen Symbols 53 entschieden. Dieser Wert wird mittels eines Rückkopplungsfilters 54 zurückgekoppelt und von dem Ausgangssignal des Filters 51 subtrahiert. Dadurch wird ein intersymbolinterferenzfreies Signal am Entscheider 52 erreicht. Dieser Decoder ist mit sehr geringem Verarbeitungsaufwand zu realisieren. Gleichzeitig ist jedoch auch hier die Bitfehlerwahrscheinlichkeit suboptimal, da nicht sämtliche zur Verfügung stehenden Informationen das Sendesignal betreffend zur Decodierung genutzt werden.

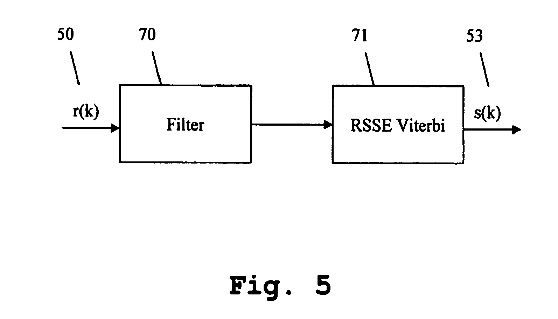

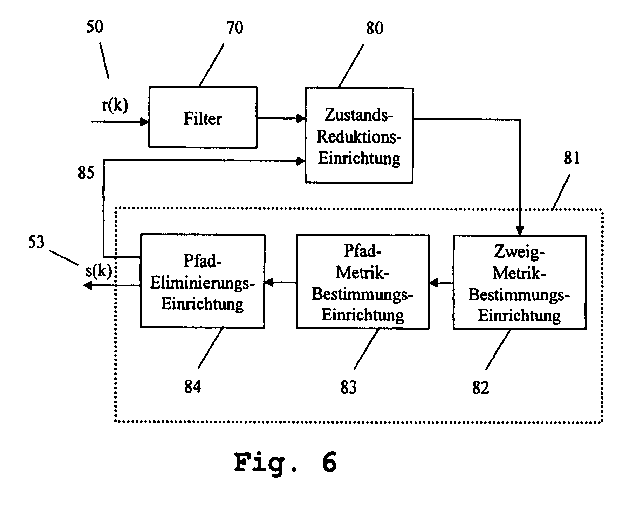

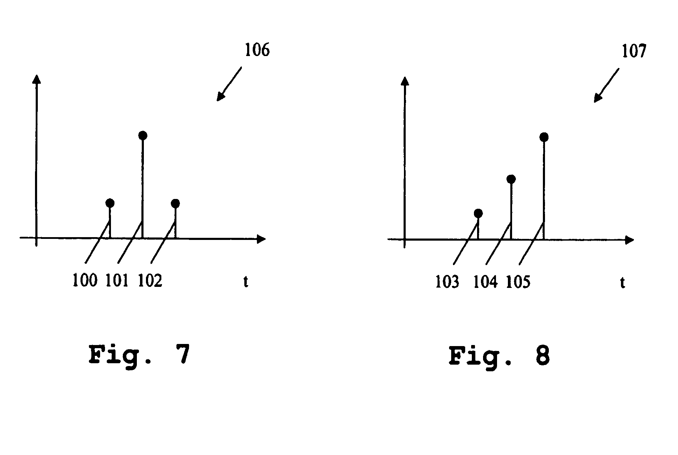

In Fig. 5 wird ein erstes Blockdiagramm eines Ausführungsbeispiels der erfindungsgemäßen Vorrichtung dargestellt. Die Empfangssymbolfolge 50 wird von einem Filter 70 gefiltert. Das Filter stellt zunächst eine Minimalphasigkeit des Empfangssignals 50 her. Dieser Vorgang wird anhand der Fig. 7 und 8 näher erläutert. Anschließend wird das Signal von einem modifizierten Viterbi-Decoder 71, welcher die decodierte Sendesymbolfolge 53 ausgibt, decodiert. Der Aufbau und die Funktionsweise des modifizierten Viterbi-Decoders werden anhand Fig. 6 näher dargestellt.

Fig. 6 zeigt ein zweites Blockdiagramm eines Ausführungsbeispiels der erfindungsgemäßen Vorrichtung. Wie in Fig. 5 dargestellt wird die Empfangssymbolfolge 50 von einem Filter 70 gefiltert, um Minimalphasigkeit herzustellen. Dieser Vorgang wird anhand der Fig. 7 und 8 näher erläutert. Anschließend durchläuft das Signal eine Zustands-Reduktions-Einrichtung 80, welche mit Hilfe bereits decodierter Symbole 85 eine Reduktion der zulässigen gegenwärtigen Symbole vornimmt. Hierzu werden gewichtete decodierte Symbole von dem intersymbolinterferenzbehafteten Empfangssymbol subtrahiert. Das resultierende Symbol ist ein intersymbolinterferenzfreies Symbol.

Aus der Position dieses Symbols im eingesetzten Modulationsschema des faltungscodierten Signals wird eine bestimmte Anzahl Nachbarsymbole, z.B. bei Phasenmodulation zwei Nachbarsymbole, als einzige zulässige Symbole bestimmt. Gemeinsam mit der gefilterten Eingangssymbolfolge 50 wird die Information, zulässige Zustände betreffend, an eine Zweig-Metrik-Bestimmungs-Einrichtung 82 weitergeleitet, welche lediglich für Zweige, welche zu einem der zulässigen Symbole führen, die Metrik bestimmt. Die Metriken der zulässigen Zweige wird an die Pfad-Metrik-Bestimmungs-Einrichtung 83 weitergeleitet. Diese berechnet die Pfad-Metriken der zulässigen Pfade aus den Zweig-Metriken der zulässigen Zweige durch Addition. Die Pfad-Metriken werden an die Pfad-Eliminierungs-Einrichtung 84 übergeben, welche den wahrscheinlichsten Pfad auswählt und die übrigen Pfade eliminiert. Der verbleibende Pfad ergibt direkt die decodierten Symbole 53. Der Block 81 entspricht dabei einem herkömmlichen Viterbi-Decoder.

Fig. 7 zeigt die Impulsantwort eines beispielhaften Sendefilters für faltungscodierte Signale. Die Impulsantwort 106 des beispielhaften Sendefilters setzt sich aus drei Komponenten 100, 101, 102 zusammen. Die dem gegenwärtigen Symbol entsprechende Komponente 102 ist dabei nicht die stärkste Komponente der Impulsantwort.

In Fig. 8 wird die durch ein Filter auf Empfangsseite umgeformte Impulsantwort eines beispielhaften Sendefilters für faltungscodierte Signale dargestellt. Die gefilterte Impulsantwort 107 des beispielhaften Sendefilters setzt sich aus drei Komponenten 103, 104, 105 zusammen. Die dem gegenwärtigen Symbol entsprechende Komponente 105 ist hier die stärkste Komponente der Impulsantwort.

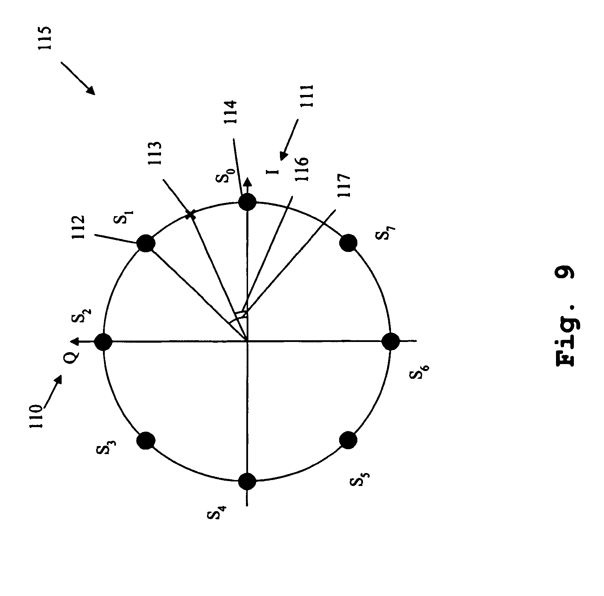

Fig. 9 zeigt ein erstes beispielhaftes Modulationsschema. Bei dem hier dargestellten Modulationsschema 115 handelt es sich um eine 8-stufige Phasenmodulation. Die Modulationsstufen S₀ - S₇ entsprechen den Zuständen der Decodierung aus den Fig. 2, 3. Die Modulationsstufen S₀ - S₇ sind durch Punkte auf einem Einheitskreis in dem komplexen Raum, aufgespannt durch die Inphase-Komponente 111 und die Quaternär-Komponente 110, gebildet. Jede Modulationsstufe S₀ - S₇ zeichnet sich durch einen diskreten Phasenwinkel aus. So ist die Modulationsstufe S₁ beispielsweise durch den Phasenwinkel 117 festgelegt. Jeder Punkt auf dem Einheitskreis hat dabei zwei Modulationsstufen als direkte Nachbarn. Jede weitere Modulationsstufe neben den beiden direkten Nachbarn ist deutlich weiter entfernt. Wird durch die Symbol-Reduktions-Einrichtung 80 aus Fig. 6 das intersymbolinterferenzfreie Symbol 113 mit dem Phasenwinkel 116 ermittelt, so sind die beiden zulässigen Symbole bei diesem Modulationsschema 115 die Modulationsstufen S₀ 114 und S₁ 112.

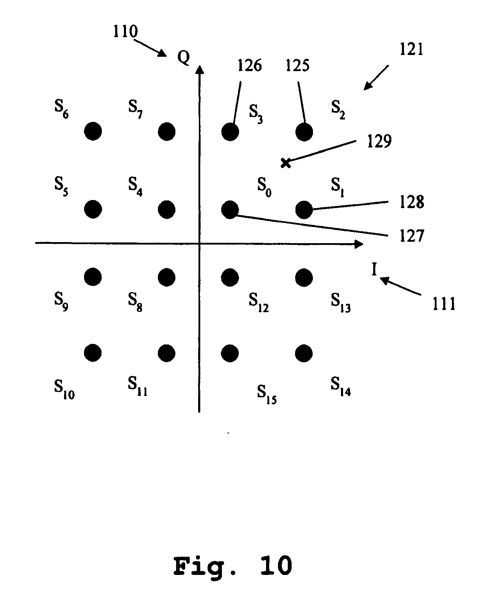

In Fig. 10 wird ein zweites beispielhaftes Modulationsschema dargestellt. Bei dem hier dargestellten Modulationsschema 120 handelt es sich um eine 16-stufige Quaternär-Amplituden-Modulation. Hier sind 16 Modulationsstufen S₀ - S₁₅ in dem komplexen Raum, aufgespannt durch die Inphase-Komponente 111 und die Quaternär-Komponente 110, angeordnet. Jede Modulationsstufe S₀ - S₁₅ zeichnet sich durch einen diskreten Wert der Inphase-Komponente 111 und der Quaternär-Komponente 110 aus. Aufgrund der Anordnung der Modulationsstufen S₀ - S₁₅ ergeben sich für jeden Punkt innerhalb des Modulationsschemas 121 im komplexen Raum 4 Modulationsstufen als direkte Nachbarn. Jede weitere Modulationsstufe neben den vier direkten Nachbarn ist deutlich weiter entfernt. Wird durch die Symbol-Reduktions-Einrichtung 80 aus Fig. 6 das intersymbolinterferenzfreie Symbol 129 ermittelt, so sind die vier zulässigen Symbole bei diesem Modulationsschema 121 die Modulationsstufen S₀ 127, S₁ 128, S₂ 125 und S₃ 126.

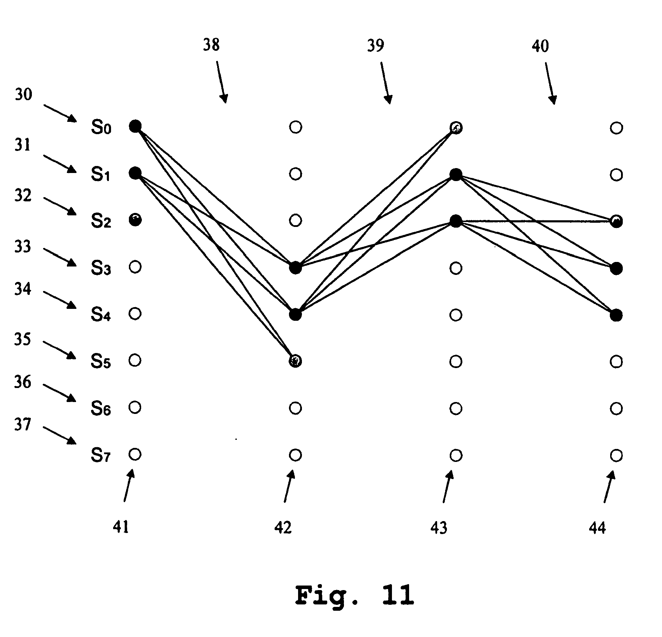

Fig. 11 zeigt ein beispielhaftes Zustandsdiagramm eines ersten Ausführungsbeispiels des erfindungsgemäßen Decoders. Das Zustandsdiagramm ist nun gegenüber den Zustandsdiagrammen aus Fig. 2 und 3 stark vereinfacht. Hier ist eine Reduktion der zulässigen Folgezustände auf 3 dargestellt. Gleichzeitig ist eine Reduktion der zu verfolgenden Pfade auf die zwei wahrscheinlichsten dargestellt. So ergibt sich ein drastisch verringerter Verarbeitungsaufwand. Durch die Kombination der Reduktion der Folgesymbole und der Pfadanzahl wird der Verarbeitungsaufwand besonders stark gesenkt. Die Bitfehlerwahrscheinlichkeit ist gegenüber einer vollständigen Analyse sämtlicher Zustände und Pfade erhöht. Das Verhältnis der Bitfehlerrate gegenüber dem Verarbeitungsaufwand ist jedoch sehr viel günstiger.

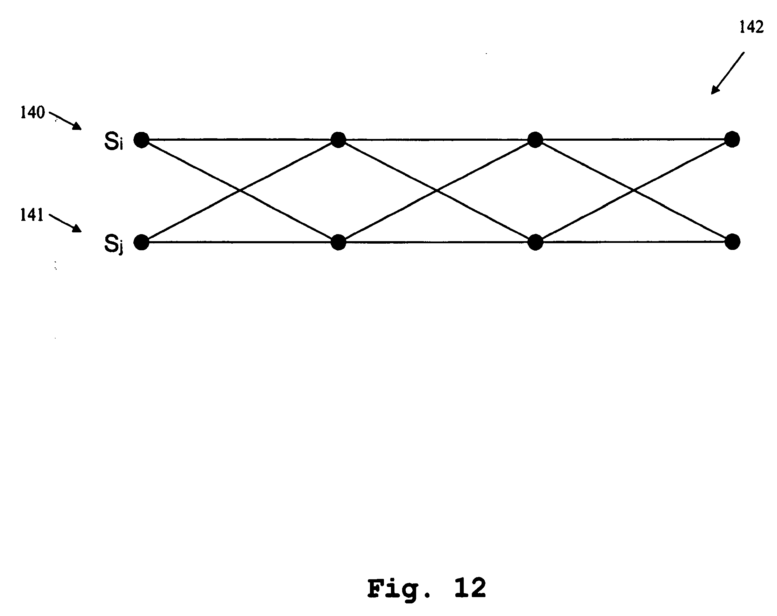

In Fig. 12 wird ein beispielhaftes Zustandsdiagramm eines zweiten Ausführungsbeispiels des erfindungsgemäßen Decoders dargestellt. Auch hier wird ein vereinfachtes Zustandsdiagramm 142 dargestellt. Durch Beschränkung der zulässigen Zustände auf zwei zulässige Zustände 140 und 141 und der Pfadanzahl auf zwei ergibt sich eine sehr geringe Zahl von zu berechnenden Pfaden.

Fig. 13 zeigt ein Diagramm der resultierenden Bitfehlerwahrscheinlichkeiten verschiedener Decodier-Verfahren. Über dem Signal-Rausch-Verhältnis ist die resultierende Bitfehlerrate bei Decodierung mit unterschiedlichen Decodern dargestellt. Ein herkömmlicher Decoder 160, welcher Intersymbolinterferenz nicht ausgleicht, erzielt nur eine sehr hohe Bitfehlerrate. Ein besseres Ergebnis liefert der in Fig. 4 dargestellte MMSE-DFE Decoder. Ein Viterbi-Decoder 162, welcher das vollständige Zustandsdiagramm auswertet, liefert ein optimales Ergebnis. Ein nur unwesentlich schlechteres Ergebnis liefert der erfindungsgemäße modifizierte Viterbi-Decoder 163, welcher jedoch einen wesentlich geringeren Verarbeitungsaufwand benötigt, als der vollständige Viterbi-Decoder.

Die Erfindung ist nicht auf die dargestellten Ausführungsbeispiel beschränkt. Wie bereits erwähnt, können unterschiedliche Arten faltungsbasierter Signale decodiert werden. So ist ein Einsatz im Mobilfunk, wie auch in der Wiedergewinnung aufgezeichneter Daten, z.B. auf Festplatten, denkbar. Alle vorstehend beschriebenen Merkmale oder in den Figuren gezeigten Merkmale sind im Rahmen der Erfindung beliebig miteinander kombinierbar.

## Patentansprüche

1. Verfahren zum Decodieren von faltungscodierten Empfangssymbolen (50),
wobei Sendedaten mit einem Modulationsschema zu Symbolen (10) moduliert werden,
wobei die Symbole (10) mit einem Sendefilter zu faltungscodierten Sendesymbolen (13) codiert werden,
wobei ein faltungscodiertes Sendesymbol (13) Anteile mehrerer zeitlich nacheinander angeordneter Symbole (10) enthält,
wobei die Sendesymbole (13) über einen Übertragungskanal übertragen werden,
wobei die übertragenen Sendesymbole (13) als Empfangssymbole (50) empfangen werden,
wobei Empfangssymbole (50) mittels eines modifizierten Viterbi-Algorithmus decodiert werden,
wobei unabhängig von der Decodierung mit dem Viterbi-Algorithmus in jedem Zustand (30-37) der Decodierung zusätzliche Informationen, die mögliche Folge-Zustände (30-37) der Decodierung betreffen, ermittelt werden, und wobei die zusätzlichen Informationen zur Einschränkung der weiteren Decodierung auf bestimmte Folgezustände (30-37) genutzt werden,
**dadurch gekennzeichnet,**
**dass** die zusätzlichen Informationen, mögliche Folge-Zustände (30-37) betreffend, durch Ermittlung eines intersymbolinterferenzfreien gegenwärtigen Empfangssymbols gewonnen werden,
**dass** das intersymbolinterferenzfreie gegenwärtige Empfangssymbol durch mit Gewichtungsfaktoren gewichtete Subtraktion vergangener intersymbolinterferenzfreier Empfangssymbole (85) von dem gegenwärtigen Empfangssymbol (50) gewonnen wird, und
**dass** die bestimmten Folgezustände (30-37) durch die Zustände geringster euklidischer Distanz zu dem intersymbolinterferenzfreien gegenwärtigen Empfangssymbol bestimmt werden.

2. Verfahren nach Anspruch 1,
**dadurch gekennzeichnet,**
**dass** das Modulationsschema (115, 121) eine Phasenmodulation (PSK) ist, und
**dass** die weitere Decodierung auf zwei bestimmte Folgezustände (112, 114) eingeschränkt wird.

3. Verfahren nach Anspruch 1 oder 2,
**dadurch gekennzeichnet,**
**dass** das Modulationsschema (115, 121) eine 8-stufige Phasenmodulation (8-PSK) oder eine 16-stufige Phasenmodulation (16-PSK) ist.

4. Verfahren nach Anspruch 1,
**dadurch gekennzeichnet,**
**dass** das Modulationsschema (115, 121) eine Quadraturamplitudenmodulation (QAM) ist, und
**dass** die weitere Decodierung auf vier bestimmte Folgezustände (125, 126, 127, 128) eingeschränkt wird.

5. Verfahren nach Anspruch 1 oder 4,
**dadurch gekennzeichnet,**
**dass** das Modulationsschema (115, 121) eine 16-stufige Quadraturamplitudenmodulation (16-QAM) oder eine 32-stufige Quadraturamplitudenmodulation (32-QAM) oder eine 64-stufige Quadraturamplitudenmodulation (64-QAM) ist.

6. Verfahren nach einem der Ansprüche 1 bis 5,
**dadurch gekennzeichnet,**
**dass** in jedem Zustand (30-37) der Decodierung mit dem Viterbi-Algorithmus zumindest ein Pfad ermittelt wird, der mit geringer Wahrscheinlichkeit die korrekte Folge von Sendesymbolen (10) ergibt, und
**dass** dieser zumindest eine Pfad aus der weiteren Decodierung eliminiert wird.

7. Verfahren nach einem der Ansprüche 1 bis 6,
**dadurch gekennzeichnet,**
**dass** die Empfangssymbole (50) vor der Decodierung gefiltert werden,
**dass** die Filterung den Einfluss vergangener Symbole (10) auf das faltungscodierte Empfangssymbol (50) reduziert, und dass die Filterung den Einfluss des gegenwärtigen Symbols auf das faltungscodierte Empfangssymbol (50) erhöht.

8. Verfahren nach Anspruch 7,
**dadurch gekennzeichnet,**
**dass** die Koeffizienten der Filterung und die Gewichtungsfaktoren zur Ermittlung des gegenwärtigen intersymbolinterferenzfreien Empfangssymbols (85) durch Optimierung bestimmt werden.

9. Vorrichtung zum Decodieren von faltungscodierten Empfangssymbolen (50) mit einem Viterbi-Decoder (81),
wobei Sendedaten mit einem Modulationsschema zu Symbolen (10) moduliert werden,
wobei die Symbole (10) mit einem Sendefilter (11) zu faltungscodierten Sendesymbolen (13) codiert werden, wobei ein faltungscodiertes Sendesymbol (13) Anteile mehrerer zeitlich nacheinander angeordneter Symbole (10) enthält,
wobei die Sendesymbole (10) über einen Übertragungskanal übertragen werden,
wobei die übertragenen Sendesymbole (10) als Empfangssymbole (50) empfangen werden,
wobei der Viterbi-Decoder (81) die Empfangssymbole (50) mittels eines modifizierten Viterbi-Algorithmus decodiert, wobei die Empfangssymbole (50) vor Durchlaufen des Viterbi-Decoders (81) von einer Zustands-Reduktions-Einrichtung (80) verarbeitet werden,
wobei die Zustands-Reduktions-Einrichtung (80) unabhängig von der Decodierung durch den Viterbi-Decoder (81) in jedem Zustand (30-37) der Decodierung zusätzliche Informationen, die mögliche Folge-Zustände (30-37) der Decodierung betreffen, ermittelt, und
wobei die Zustands-Reduktions-Einrichtung (80) die zusätzlichen Informationen nutzt, um die Decodierung durch den Viterbi-Decoder (81) auf bestimmte Folgezustände (30-37) einzuschränken,
**dadurch gekennzeichnet,**
**dass** die Zustands-Reduktions-Einrichtung (80) die zusätzlichen Informationen, mögliche Folge-Zustände (30-37) betreffend, durch Ermittlung eines intersymbolinterferenzfreien gegenwärtigen Empfangssymbols gewinnt,
**dass** die Zustands-Reduktions-Einrichtung (80) das intersymbolinterferenzfreie gegenwärtige Empfangssymbol durch gewichtete Subtraktion vergangener intersymbolinterferenzfreier Empfangssymbole (85) von dem gegenwärtigen Empfangssymbol (50) gewinnt, und
**dass** die Zustands-Reduktions-Einrichtung (80) die Folgezustände (30-37) durch Ermittlung der Zustände geringster euklidischer Distanz zu dem intersymbolinterferenzfreien gegenwärtigen Empfangssymbol bestimmt.

10. Vorrichtung nach Anspruch 9,
**dadurch gekennzeichnet,**
**dass** das Modulationsschema (115, 121) eine Phasenmodulation (PSK) ist, und
**dass** die Zustands-Reduktions-Einrichtung (80) die weitere Decodierung auf zwei bestimmte Folgezustände (112, 114) einschränkt.

11. Vorrichtung nach Anspruch 9 oder 10,
**dadurch gekennzeichnet,**
**dass** das Modulationsschema (115, 121) eine 8-stufige Phasenmodulation (8-PSK) oder eine 16-stufige Phasenmodulation (16-PSK) ist.

12. Vorrichtung nach Anspruch 9,
**dadurch gekennzeichnet,**
**dass** das Modulationsschema (115, 121) eine Quadraturamplitudenmodulation (QAM) ist, und
**dass** die Zustands-Reduktions-Einrichtung (80) die weitere Decodierung auf vier bestimmte Folgezustände (125, 126, 127, 128) einschränkt.

13. Vorrichtung nach Anspruch 9 oder 12,
**dadurch gekennzeichnet,**
**dass** das Modulationsschema (115, 121) eine 16-stufige Quadraturamplitudenmodulation (16-QAM) oder eine 32-stufige Quadraturamplitudenmodulation (32-QAM) oder eine 64-stufige Quadraturamplitudenmodulation (64-QAM) ist.

14. Vorrichtung nach einem der Ansprüche 9 bis 13,
**dadurch gekennzeichnet,**
**dass** der Viterbi-Decoder (81) in jedem Zustand (30-37) der Decodierung mit dem Viterbi-Algorithmus zumindest einen Pfad ermittelt, der mit geringer Wahrscheinlichkeit die korrekte Folge von Sendesymbolen (10) ergibt, und
**dass** der Viterbi-Decoder (81) diesen zumindest einen Pfad aus der weiteren Decodierung eliminiert.

15. Vorrichtung nach einem der Ansprüche 9 bis 14,
**dadurch gekennzeichnet,**
**dass** ein Filter (70) die Empfangssymbole (50) vor der Decodierung filtert,
**dass** die Filterung durch das Filter (70) den Einfluss vergangener Symbole (10) auf das faltungscodierte Empfangssymbol (50) reduziert, und
**dass** die Filterung durch das Filter (70) den Einfluss des gegenwärtigen Symbols (10) auf das faltungscodierte Empfangssymbol erhöht.

16. Vorrichtung nach Anspruch 15,
**dadurch gekennzeichnet,**
**dass** die Koeffizienten des Filters (70) und die Gewichtungsfaktoren zur Ermittlung des gegenwärtigen intersymbolinterferenzfreien Empfangssymbols durch Optimierung bestimmt werden.

## Claims

1. Method for decoding convolution-encoded reception symbols (50),
wherein transmission data are modulated with a modulation scheme to form symbols (10),
wherein the symbols (10) are encoded with a transmission filter to form convolution-encoded transmission symbols (13),
wherein a convolution-encoded transmission symbol (13) contains components of several symbols (10) arranged in time succession,
wherein the transmission symbols (13) are transmitted via a transmission channel,
wherein the transmitted transmission symbols (13) are received as reception symbols (50),
wherein reception symbols (50) are decoded by means of a modified Viterbi algorithm,
wherein, independently of the decoding with the Viterbi algorithm, additional information, which relates to possible consequential states (30-37) of the decoding, is determined in every state (30-37) of the decoding, and
wherein the additional information is used to restrict the further decoding to given consequential states (30-37),
**characterised in that**
the additional information relating to possible consequential states (30-37) is obtained by determining an inter-symbol, interference-free, present reception symbol,
that the inter-symbol, interference-free, present reception symbol is obtained by subtraction weighted with weighting factors of past inter-symbol, interference-free reception symbols (85) from the present reception symbol (50), and that the given consequential states (30-37) are determined through the states of minimum Euclidean distance to the inter-symbol, interference-free, present reception symbol.

2. Method according to claim 1,
**characterised in that**
the modulation scheme (115, 121) is a phase modulation (PSK), and that further decoding is restricted to two given consequential states (112, 114).

3. Method according to claim 1 or 2,
**characterised in that**
the modulation scheme (115, 121) is an 8-stage phase modulation (8-PSK) or a 16-stage phase modulation (16-PSK).

4. Method according to claim 1,
**characterised in that**
the modulation scheme (115, 121) is a quadrature-amplitude modulation (QAM), and that the further decoding is restricted to four given consequential states (125, 126, 127, 128).

5. Method according to claim 1 or 4,
**characterised in that**
the modulation scheme (115, 121) is a 16-stage quadrature-amplitude modulation (16-QAM) or a 32-stage quadrature-amplitude modulation (32-QAM) or a 64-stage quadrature-amplitude modulation (64-QAM).

6. Method according to any one of claims 1 to 5,
**characterised in that**,
in every state (30-37) of the decoding with the Viterbi algorithm, at least one path is determined, which gives the correct sequence of transmission symbols (10) with a low probability, and
that this at least one path is eliminated from the further decoding.

7. Method according to any one of claims 1 to 6,
**characterised in that**
the reception symbols (50) are filtered before the decoding,
that the filtering reduces the influence of past symbols (10) on the convolution-encoded reception symbol (50), and that the filtering increases the influence of the present symbol on the convolution-encoded reception symbol (50).

8. Method according to claim 7,
**characterised in that**
the coefficients of the filtering and the weighting factors for determining the present, inter-symbol, interference-free reception symbol (85) are determined through optimisation.

9. Device for decoding convolution-encoded reception symbols (50) with a Viterbi-decoder (81),
wherein transmission data are modulated with a modulation scheme to form symbols (10),
wherein the symbols (10) are encoded with a transmission filter (11) to form convolution-encoded transmission symbols (13),
wherein a convolution-encoded transmission symbol (13) contains components of several symbols (10) arranged in time succession,
wherein the transmission symbols (10) are transmitted via a transmission channel,
wherein the transmitted transmission symbols (10) are received as reception symbols (50),
wherein the Viterbi decoder (81) decodes the reception symbols (50) by means of a modified Viterbi algorithm,
wherein the reception symbols (50) are processed by a state-reduction device (80) before running through the Viterbi decoder (81),
wherein, independently from the decoding by the Viterbi decoder (81), in every state (30-37) of the decoding, the state-reduction device (80) determines additional information, which relates to possible consequential states (30-37) of the decoding, and
wherein the state-reduction device (80) uses the additional information in order to restrict the decoding by the Viterbi decoder (81) to given consequential states (30-37),
**characterised in that**
the state-reduction device (80) obtains the additional information relating to possible consequential states (30-37) by determining an inter-symbol, interference-free, present reception symbol,
that the state-reduction device (80) obtains the inter-symbol, interference-free, present reception symbol through weighted subtraction of past inter-symbol, interference-free reception symbols (85) from the present reception symbol (50), and
that the state-reduction device (80) determines the consequential states (30-37) by determining the states of minimum Euclidean distance to the inter-symbol, interference-free, present reception symbol.

10. Device according to claim 9,
**characterised in that**
the modulation scheme (115, 121) is a phase modulation (PSK), and
that the state-reduction device (80) restricts the further decoding to two given consequential states (112, 114).

11. Device according to claim 9 or 10,
**characterised in that**
the modulation scheme (115, 121) is an 8-stage phase modulation (8-PSK) or a 16-stage phase modulation (16-PSK).

12. Device according to claim 9,
**characterised in that**
the modulation scheme (115, 121) is a quadrature-amplitude modulation (QAM), and that the state-reduction device (80) restricts the further decoding to four given consequential states (125, 126, 127, 128).

13. Device according to claim 9 or 12,
**characterised in that**
the modulation scheme (115, 121) is a 16-stage quadrature-amplitude modulation (16-QAM) or a 32-stage quadrature-amplitude modulation (32-QAM) or a 64-stage quadrature-amplitude modulation (64-QAM).

14. Device according to any one of claims 9 to 13,
**characterised in that**,
in every state (30-37) of the decoding with the Viterbi algorithm, the Viterbi decoder (81) determines at least one path, which gives the correct sequence of transmission symbols (10) with a low probability, and
that the Viterbi-decoder (81) eliminates this at least one path from the further decoding.

15. Device according to any one of claims 9 to 14,
**characterised in that**
a filter (70) filters the reception symbols (50) before the decoding,
that the filtering through the filter (70) reduces the influence of past symbols (10) on the convolution-encoded reception symbol (50), and that the filtering through the filter (70) increases the influence of the present symbol on the convolution-encoded reception symbol (50).

16. Device according to claim 15,
**characterised in that**
the coefficients of the filter (70) and the weighting factors for determining the present, inter-symbol, interference-free reception symbol are determined through optimisation.

## Revendications

1. Procédé pour décoder des symboles de réception codés par convolution (50),
dans lequel des données d'envoi sont modulées en symboles (10) par un schéma de modulation,
dans lequel les symboles (10) sont codés en symboles d'envoi codés par convolution (13) par un filtre d'envoi,
dans lequel un symbole d'envoi (13) codé par convolution comporte des parties de plusieurs symboles consécutifs (10),
dans lequel les symboles d'envoi (13) sont transmis par l'intermédiaire d'un canal de transmission,
dans lequel les symboles d'envoi transmis (13) sont reçus en tant que symboles de réception (50),
dans lequel les symboles de réception (50) sont décodés au moyen d'un algorithme de Viterbi modifié,
dans lequel, indépendamment du décodage par l'algorithme de Viterbi dans chaque état (30-37) du décodage, des informations supplémentaires, qui correspondent aux conséquences possibles (30-37) du décodage, sont déterminées, et
dans lequel les informations supplémentaires sont utilisées pour limiter un autre décodage à des conséquences déterminées (30-37),
**caractérisé en ce que**
les informations supplémentaires, correspondant aux conséquences possibles (30-37), sont obtenues grâce à la détermination d'un symbole de réception présent exempt d'interférences intersymboles,
**en ce que** le symbole présent exempt d'interférences intersymboles est obtenu grâce à une soustraction pondérée par des facteurs de pondération des symboles de réception exempts d'interférences intersymboles précédents (85) par le symbole de réception actuel (50), et
**en ce que** les conséquences déterminées (30-37) sont déterminées par les états de la plus petite distance euclidienne par rapport au symbole de réception actuel exempt d'interférences intersymboles.

2. Procédé selon la revendication 1, **caractérisé en ce que**
le schéma de modulation (115, 121) est une modulation de phase (PSK), et
**en ce que** l'autre décodage est limité à deux conséquences déterminées (112, 114).

3. Procédé selon la revendication 1 ou 2, **caractérisé en ce que**
le schéma de modulation (115, 121) est une modulation de phase à 8 états (8-PSK) ou une modulation de phase à 16 états (16-PSK).

4. Procédé selon la revendication 1, **caractérisé en ce que**
le schéma de modulation (115, 121) est une modulation d'amplitude en quadrature (QAM), et
**en ce que** l'autre décodage est limité à quatre états consécutifs déterminés (125, 126, 127, 128).

5. Procédé selon la revendication 1 ou 4, **caractérisé en ce que**
le schéma de modulation (115, 121) est une modulation d'amplitude en quadrature à 16 états (16-QAM) ou une modulation d'amplitude en quadrature à 32 états (32-QAM) ou une modulation d'amplitude en quadrature à 64 états (64-QAM)_{.}

6. Procédé selon l'une des revendications 1 à 5, **caractérisé en ce que**
dans chaque état (30-37) du décodage, est déterminé grâce à l'algorithme de Viterbi au moins un trajet, qui résulte de la suite correcte de symboles d'envoi (10) avec une faible probabilité, et
**en ce que** ce au moins un trajet est éliminé de l'autre décodage.

7. Procédé selon l'une des revendications 1 à 6, **caractérisé en ce que**
les symboles de réception (50) sont filtrés avant le décodage,
**en ce que** le filtrage réduit l'influence des symboles précédents (10) sur le symbole de réception codé par convolution (50),
et **en ce que** le filtrage augmente l'influence des symboles précédents sur le symbole de réception codé par convolution (50).

8. Procédé selon la revendication 7, **caractérisé en ce que**
les coefficients de filtrage et les facteurs de pondération pour la détermination du symbole de réception exempt d'interférences intersymboles actuel (85) sont déterminés par optimisation.

9. Dispositif pour décoder des symboles de réception codés par convolution (50) grâce à un décodeur de Viterbi (81),
dans lequel des données d'envoi sont modulées par un schéma de modulation en symboles (10),
dans lequel les symboles (10) sont codés par un filtre d'envoi (11) en symboles d'envoi codés par convolution (13),
dans lequel un symbole d'envoi codé par convolution (13) comporte des parties de plusieurs symboles consécutifs (10),
dans lequel les symboles d'envoi (10) sont transmis par l'intermédiaire d'un canal de transmission,
dans lequel les symboles d'envoi transmis (10) sont reçus en tant que symboles de réception (50),
dans lequel 1 le décodeur de Viterbi (81) décode les symboles dé réception (50) au moyen d'un algorithme de Viterbi modifié,
dans lequel les symboles de réception (50) sont traités avant traversée du décodeur de Viterbi (81) par un dispositif de réduction d'état (80),
dans lequel le dispositif de réduction d'état (80) détermine, indépendamment du décodage par le décodeur de Viterbi (81) dans chaque état (30-37) du décodage, des informations supplémentaires, qui correspondent aux conséquences possibles (30-37) du décodage, et
dans lequel le dispositif de réduction d'état (80) utilise les informations supplémentaires pour limiter le décodage par le décodeur de Viterbi (81) aux conséquences déterminées (30-37),
**caractérisé en ce que**
le dispositif de réduction d'état (80) obtient les informations supplémentaires, correspondant aux conséquences possibles (30-37), par détermination d'un symbole de réception précédent exempt d'interférences intersymboles,
**en ce que** le dispositif de réduction d'état (80) obtient le symbole de réception actuel exempt d'interférences intersymboles grâce à une soustraction pondérée des symboles de réception exempts d'interférences intersymboles précédents (85) par le symbole de réception actuel (50), et
**en ce que** le dispositif de réduction d'état (80) détermine les conséquences (30-37) par détermination des états de la plus petite distance euclidienne par rapport au symbole de réception actuel exempt d'interférences intersymboles.

10. Dispositif selon la revendication 9, **caractérisé en ce que**
le schéma de modulation (115, 121) est une modulation de phase (PSK), et
**en ce que** le dispositif de réduction d'état (80) limite l'autre décodage à deux conséquences déterminées (112, 114).

11. Dispositif selon la revendication 9 ou 10, **caractérisé en ce que**
le schéma de modulation (115, 121) est une modulation de phase à 8 états (8-PSK) ou une modulation de phase à 16-états (16-PSK).

12. Dispositif selon la revendication 9, **caractérisé en ce que**
le schéma de modulation (115, 121) est une modulation d'amplitude en quadrature (QAM), et
**en ce que** le dispositif de réduction d'état (80) limite l'autre décodage à quatre états consécutifs déterminés (125, 126, 127, 128).

13. Dispositif selon la revendication 9 ou 12, **caractérisé en ce que**
le schéma de modulation (115, 121) est une modulation d'amplitude en quadrature à 16 états (16-QAM) ou une modulation d'amplitude en quadrature à 32 états (32-QAM) ou une modulation d'amplitude en quadrature à 64 états (64-QAM).

14. Dispositif selon l'une des revendications 9 à 13, **caractérisé en ce que**
le décodeur de Viterbi (81) dans chaque état (30-37) du décodage détermine grâce à l'algorithme de Viterbi au moins un trajet, qui résulte avec une faible probabilité de la suite correcte de symboles d'envoi (10), et
**en ce que** le décodeur de Viterbi (81) élimine ce au moins un trajet de l'autre décodage.

15. Dispositif selon l'une des revendications 9 à 14, **caractérisé en ce que**
un filtre (70) filtre les symboles de réception (50) avant le décodage,
**en ce que** le filtrage par le filtre (70) réduit l'influence des symboles précédents (10) sur le symbole de réception codé par convolution (50), et
**en ce que** le filtrage par le filtre (70) augmente l'influence du symbole actuel (10) sur le symbole de réception codé par convolution.

16. Dispositif selon la revendication 15, **caractérisé en ce que**
les coefficients du filtre (70) et les facteurs de pondération pour la détermination du symbole de réception exempt d'interférences intersymboles actuel sont déterminés par optimisation.
